# EUROPEAN PATENT SPECIFICATION

(11) **EP 0 822 740 B1**
(45) Date of publication and mention of the grant of the patent: **07.01.2004**
(21) Application number: 97250221.5
(22) Date of filing: 26.07.1997
(51) Int. Cl.: H05K 13/00, H01R 13/66, H01R 13/629, H05K 13/04

(54) **Automatic mounting or connecting recognition apparatus**
Gerät für automatische Verbindungserkennung
Appareil avec détection automatique de connexion

(30) Priority: 29.07.1996 JP 19934896
(43) Date of publication of application: 04.02.1998
(73) Proprietor: NEC CORPORATION, Tokyo (JP)
(72) Inventor: Fugo, Masatoshi, c/o NEC Yonezawa Ltd., Yonezawa-shi, Yamagata (JP)
(74) Representative: Patentanwälte Wenzel & Kalkoff

(56) References cited:
- EP-A- 0 435 326
- DE-C- 4 324 011
- PATENT ABSTRACTS OF JAPAN vol. 016, no. 267 (E-1217), 16 June 1992 & JP 04 062897 A (SONY CORP), 27 February 1992,
- PATENT ABSTRACTS OF JAPAN vol. 017, no. 245 (E-1365), 17 May 1993 & JP 04 369128 A (NEC CORP), 21 December 1992,

## Description

### BACKGROUND OF THE INVENTION

### 1. Field of the Invention

The present invention relates to the circuit and construction of a printed circuit board and connector, and more specifically to an automatic mounting or connecting recognition apparatus and a method for determining the mounting or connecting of electric functional components in electronic information devices including computers whereby it can be easily recognized and determined whether or not an electrical component or a connector is mounted on a printed circuit board.

### 2. Description of Related Art

In the electronic information devices including computers, it is generally carried out that various kinds of electric functional component including electric or electronic components such as resistors, capacitors, transistors, inductances, light emission devices, etc., various kinds of chips including highly integrated circuit components (LSI), micro-computer, CPU, etc., and liquid crystal displays are mounted at predetermined positions of the printed circuit board or separate printed circuit boards. Aforementioned electric functional components, various kinds of devices including IC cards, memory cards, driving device for driving memory mediums, etc., are also included in the term electric functional component in the present invention, are connected to a predetermined connector which is provided on the printed circuit board through a suitable connecting means such as a connector.

On the other hand, when such an electric functional component or device is connected to or mounted on the printed circuit board, it should be necessary to confirm whether or not such electric functional component is surely mounted or connected to the predetermined position of the printed circuit board.

In the past, however, in order to recognize the mounting or connecting of the electric functional component, for example, when it is inspected whether or not each one of plurality of lead terminals of a predetermined chip are accurately mounted and connected to a plurality of electrodes formed on the printed circuit board and each corresponds to the respective lead terminals thereof, the inspecting method is carried out with a specially prepared measuring and inspecting means in the mounting operation process for the printed circuit board.

Therefore, the separate inspection means and separate inspection process according to the conventional method lead to an increase in the number of processing stages, reduction of the efficiency of the production and throughput as well as increase in production costs.

An embodiment of a conventional automatic mounting or connection recognition method about the electric functional component is shown in Japanese Unexamined Patent Publication (KOKAI) No. 5-327284.

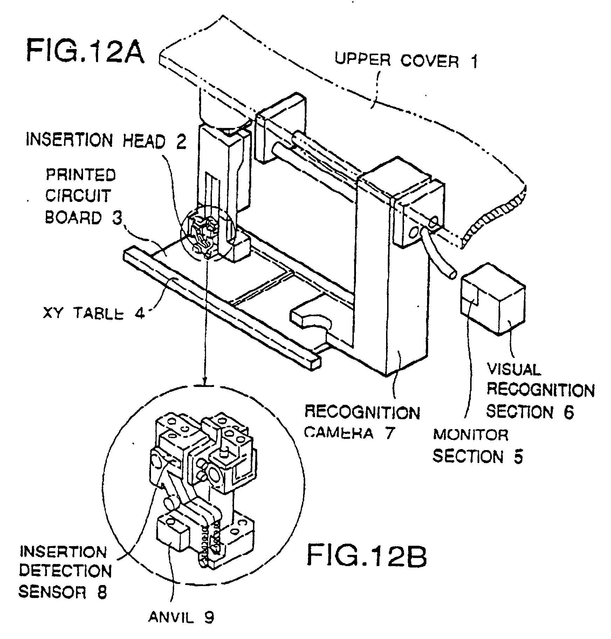

This conventional electric functional component mounting method will be explained hereunder with reference to Fig. 12(A) and 12(B).

Fig. 12(A) and 12(B) show perspective views of the conventional electric functional component mounting device wherein an insertion detection signal which is output when leads are cut is used as an information signal by an insertion detection sensor 8 to perform detection of the existence of a lead with respect to a component insertion hole on the board, an insertion error being detected when there is no lead.

The first problem with the above-cited technology is the need to have an insertion detection sensor, which requires space and the cost of installing equipment.

The reason for this is that the insertion detection sensor is a precision device, having a complex construction and high cost, which also requires installation location.

The second problem with the above-cited technology is that it can only be used in the manufacturing process of the printed circuit board.

The reason for this is that it is not possible to mount an insertion detection sensor to the manufactured product.

Accordingly, the above-mentioned conventional technology cannot be used when some electric functional component should be exchanged or the connector should be re-connected due to a break or malfunction of the electric functional component when an ordinary user is using the electronic information device.

On the other hand, even in the past, there has been no pertinent method for automatically determining whether or not the electric functional components are surely mounted on the printed circuit board or connectors are surely connected to a connector provided on the printed circuit board, when the electric functional components are to be mounted on the printed circuit board or the electric functional components or devices including IC cards, memory cards, electronic devices including driving means for driving memory mediums and so on, are to be connected to the connector already mounted on the printed circuit board through a suitable connector.

Thus, the user himself carries out such inspections manually each time after electric power has been supplied to the electronic information devices.

JP-A-04 062 897 discloses a printed circuit board comprising a control and a detection circuit for detecting matching or unmatching between the circuit board and a mother board.

Therefore, in view of the above-described drawbacks in the prior art, an object of the present invention is to provide an automatic mounting or connecting recognition apparatus in which a function to automatically determine whether or not the electric functional component is mounted on or connected to the printed circuit board, is built in the printed circuit board, whereby the aforementioned determination can easily be carried out on the board without separately preparing means which determines the connected condition of the electric functional component to the printed circuit board.

And further, the present invention can provide an automatic mounting or connecting recognition apparatus having a simplified circuitry for such determination by simplifying the mounting or connecting recognition circuit due to the introduction of the electric signal detecting mode thereinto for determining whether or not the electric functional component is actually mounted on the printed circuit board.

### SUMMARY OF THE INVENTION

To achieve the above-noted object, the present invention has the following basic constitution.

Specifically, a first aspect of the present invention relates to a printed circuit board comprising at least a mounting or connecting recognition circuit which is provided on the printed circuit board and which recognizes an electric functional component when an electric functional component is mounted on or connected to the printed circuit board.

The invention further relates to an automatic mounting or connecting recognition apparatus comprising such printed circuit board and to the combination of a connector comprising a mounting or connection recognition pad and such printed circuit board.

And more specifically relates to an automatic mounting or connecting recognition apparatus wherein the mounting or connecting recognition circuit which is provided on the printed circuit board, comprises a mounting or connecting recognition pad which is provided on one of the electrodes formed on the printed circuit board, and a mounting or connecting determining means which is connected to the mounting or connecting recognition circuit and determines whether or not the electric functional component is mounted on the mounting or connecting recognition pad in response to an output signal output from the mounting or connecting recognition pad.

Further, a second aspect of the present invention relates to a method for determining mounting or connection of an electric functional component used in an electronic device which comprises a printed circuit board and at least a mounting or connecting recognition circuit which provided on the printed circuit board and which recognizes an electric functional component being mounted on or connected to the printed circuit board when an electric functional component is mounted on or connected to the printed circuit board, the method comprising that when at least one predetermined connecting terminal of the electric functional component is connected to a mounting or connecting recognition pad provided on one of electrodes formed on the printed circuit board and on which or to which the electric functional component being mounted or connected , a mounting or connecting determining means provided in the mounting or connecting recognition circuit determines whether or not the electric functional component is connected to or mounted on the mounting or connecting recognition pad, in response to an output signal output from the mounting or connecting recognition pad.

Thus, since the automatic mounting or connecting recognition apparatus of the present invention has the technical constructions as mentioned above, no insertion detection sensor is required due to the mounting or connecting recognition circuit being mounted on the printed circuit board and further it is possible to reduce the surface area occupied by the automatic mounting or connecting recognition apparatus because of the method for determining whether or not an electric functional component is mounted, being introduced.

### Description of the Drawings

Fig. 1 is a perspective view which shows the configuration of one specific embodiment of an automatic mounting recognition apparatus according to the present invention;
Fig. 2 is a sectional view which shows a connecting condition formed between an electric functional component and a mounting or connecting recognition pad in the above-mentioned embodiment;
Fig. 3 is a flow-chart showing sequential processes used in a mounting or connecting determining means;
Fig. 4 is a sectional view which shows a connecting condition formed between an electric functional component and a mounting or connecting recognition pad in an other embodiment of the present invention;
Fig. 5 shows a block-diagram showing a construction of the mounting or connecting recognition pad as shown in Fig. 4;
Fig. 6 is a perspective view which shows a connecting condition formed between connectors used in further separate embodiment of the present invention;
Fig. 7 is a perspective view which shows a connecting condition formed between connectors used in another embodiment of the present invention;
Fig. 8 is a perspective view which shows a connecting condition formed between connectors used in further another embodiment of the present invention;
Fig. 9 is a sectional view which shows a connecting condition formed between a connector and a mounting or connecting recognition pad in the embodiments as shown in Figs 4 to 8;
Fig. 10 is a sectional view which shows a connecting condition formed between connectors connected to each other in still further separate embodiment of the present invention;
Fig. 11 shows the configuration of the automatic mounting or connecting recognition apparatus as shown in Fig. 10; and one specific embodiment of an automatic mounting recognition apparatus according to the present invention;
Figs. 12 (A) and 12(B) are perspective views which shows an electronic component insertion apparatus in the past.

### Detailed Description of the Preferred Embodiments

Specific embodiments of present invention are described below, with reference being made to the relevant accompanying drawings.

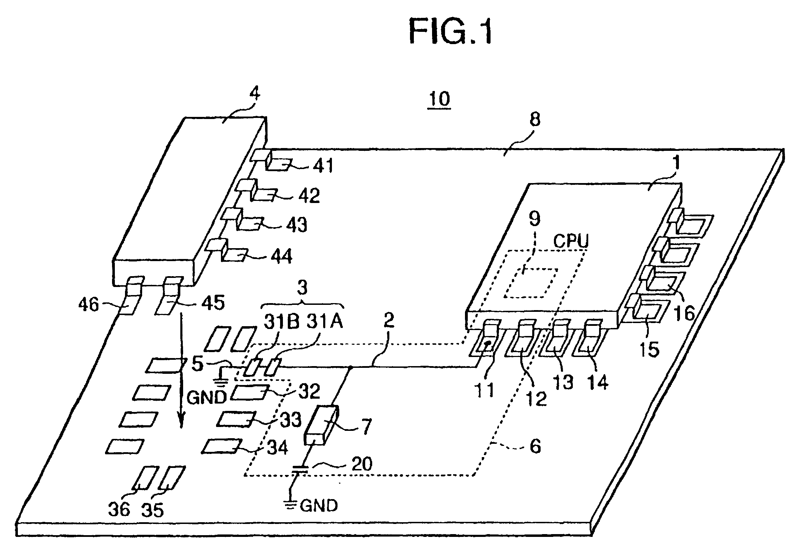

Fig. 1 is a drawing which shows the configuration of the automatic mounting or connecting recognition apparatus 10 in a first embodiment of the present invention and in that it is shown a automatic mounting or connecting recognition apparatus 10 comprising, a printed circuit board 8, and at least a mounting or connecting recognition circuit 6 which provided on the printed circuit board 8 and which recognizes an electric functional component 4 being mounted on or connected to the printed circuit board 8 when an electric functional component 4 is mounted on or connected to the printed circuit board 8.

The electric functional component as used in the automatic mounting or connecting recognition apparatus in the present invention, is not restricted but it includes, for example, electric or electronic components such as resistors, capacitors, transistors, inductance, memory cards, I.C. cards, boards and connecting connectors.

Further, the printed circuit board 8 used in the present invention is also not restricted but any kind of printed circuit board as well-known in the past, and suitable electrodes, connecting pads or connecting terminals to which the electric functional component 4 is mounted, are correctly arranged on the board, can be used.

Moreover, when an I.C. card including a memory card or a suitable connector as one of embodiment of the electric functional component 4 should be connected to the printed circuit board 8, the printed circuit board 8 which is provided with a connecting connector suitable for connecting the above-mentioned electric functional component thereon, can also be used.

In the present invention, when the predetermined electric functional components are mounted on or connected to the printed circuit board 8, a generally known mounting or connecting device is used and thus no specific electric functional component mounting or connecting device or no specific electric functional component mounting or connecting method is required.

In the present invention, however, it is necessary to confirm whether or not the electric functional components are correctly and accurately mounted on or connected to the printed circuit board 8.

Therefore, for example, one connecting terminal 41 of the connecting terminals 41, 42, 43, 44,·····of the electric functional component 4 is specifically selected as the connecting terminal to be used for such determination.

On the other hand, as the mounting or connecting recognition pad 3 forming a part of the mounting or connecting recognition circuit 6, one electrode 31 of a plurality of electrodes 31, 32, 33, 34, ····· as arranged on the printed circuit board 8, is selected to use the mounting or connecting recognition pad 3.

And thus the mounting or connecting recognition circuit 6 is constructed so that when the mounting or connecting recognition pad 3 and the selected connecting terminal 41 of the electric functional component4 which corresponds to the mounting or connecting recognition pad 3, are connected to each other, it can determine whether or not the electric functional component 4 is correctly mounted on or connected to the printed circuit board 8.

In the present invention, the automatic mounting or connecting recognition apparatus 10 does not directly determine whether or not each one of the connecting terminals 42, 43, 44, ····· of the electric functional component 4 is correctly connected to each one of the electrodes 32, 33, 34, ····· as arranged on the printed circuit board 8, respectively.

Please note that such kind of determination should be carried out by separate well-known method or devices.

As apparent from the above-mentioned explanations, it is preferable in the present invention that the mounting or connecting recognition circuit 6 which is provided on the printed circuit board 8, comprises a mounting or connecting recognition pad 3 which is provided on one electrode 31 selected from the electrodes 31, 32, 33, 34, ····· as arranged on the printed circuit board 8, and a mounting or connecting determining means 9 which is electrically connected to the mounting or connecting recognition pad 3, and which determines whether or not the electric functional component 4 is mounted on or connecting to the mounting or connecting recognition pad in response to an output signal output from the mounting or connecting recognition pad.

As explained above, the mounting or connecting recognition pad 3 of the present invention, is formed on, for example, one electrode 31 selected from the electrodes 31, 32, 33, 34, ····· as arranged on the printed circuit board 8, each being connected with the plurality of connecting terminals 41, 42, 43, 44, ····· arranged on the electric functional component 4, respectively.

And regarding the mounting or connecting recognition pad 3 of the present invention, the electrode 31 is separated into two sub-electrodes 31A and 31B to form the mounting or connecting recognition pad 3 and each of which is electrically insulated from each other and the two sub-electrodes 31A and 31B being conducted to each other when a predetermined electric terminal 41 provided on the electric functional component 4 is simultaneously connected to both sub-electrodes 31A and 31B.

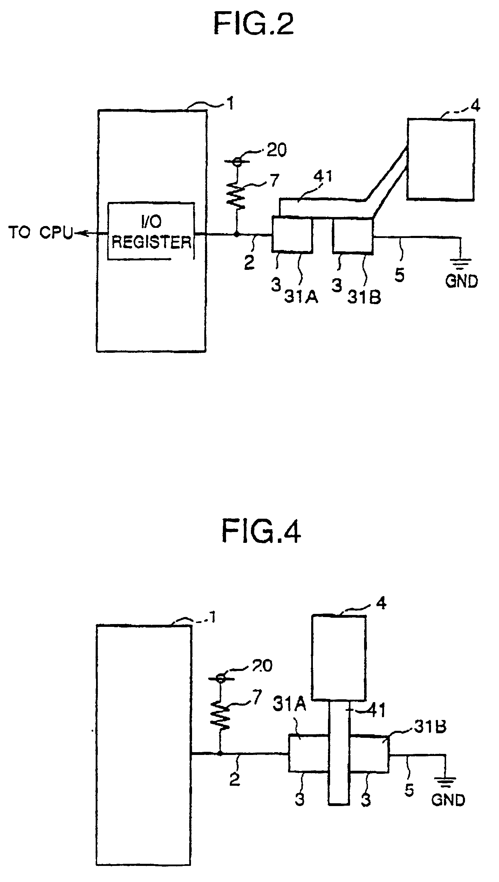

Fig. 2 shows a sectional view showing a connecting condition formed between an electric functional component 4 and a mounting or connecting recognition pad 3 in the above-mentioned first embodiment.

More specifically, as shown in Fig. 1, in the mounting or connecting recognition circuit 6 of the present invention, the mounting or connecting determining means 9 is preferably provided in a chip 1, for example a highly integrated circuit (LSI) which may be a micro-computer or the like and a connecting terminal of the mounting or connecting determining means 9 may be connected to an external devices through the connecting terminal 11 selected from the connecting terminals 11, 12, 13, 14, 15, 16····· of the chip 1.

Note that in the present invention, the mounting or connecting determining means 9 is provided in a chip 1 previously mounted on the printed circuit board 8 which is different component from the electric functional component 4.

And as shown in Fig. 1, the connecting terminal 11 of the chip 1 is connected to the one sub-electrode 31A of the mounting or connecting recognition pad 3.

On the other hand, another sub-electrode 31B of the mounting or connecting recognition pad 3 is connected to ground (GND) through a suitable wiring 5, while the sub-electrode 31A thereof is connected to the terminal 11 of the chip 1 corresponding to the connecting terminal of the mounting or connecting determining means 9 through a suitable wiring 2.

Further, in the present invention, it is preferable that the predetermined electric terminal 41 of the electric functional component 4 to be connected to the mounting or connecting recognition pad 3 is a grounding terminal.
thereof .

In the present invention, an electric potential level of the wiring 2 connecting the mounting or connecting recognition pad 3 and the mounting or connecting determining means 9 forming the mounting or connecting recognition circuit 6, should be maintained at a positive voltage level during a time when no electric functional component 4 is mounted on or connected to the predetermined position of the printed circuit board 8.

For the sake of it, a pull-up resistor 7 connected to a predetermined voltage source 20 may preferably be connected to the wiring 2 connecting the mounting or connecting recognition pad 3 and the mounting or connecting determining means 9.

Accordingly, the electric potential of the wiring 2 is kept at a predetermined voltage level by the pull-up resistor 7 in a period during when no electric functional component 4 is mounted or connected to the printed circuit board 8.

While, when the electric functional component 4 is mounted or connected to the printed circuit board 8, the mounting or connecting recognition pad 3 is become in conductive condition leading the electric potential of the wiring 2 to be changed to grounding level (GND).

Therefore, the mounting or connecting determining means 9 can recognize the fact that a certain electric functional component 4 has been mounted on or connected to the printed circuit board 8 from the detection of the electric potential of the wiring 2 being changed from a positive to zero level (GND).

Then it detects such a condition, i.e., a certain electric functional component 4 has been mounted on or connected to the printed circuit board 8, through. for example, an I/O or I/O register or the like and inform the detected result to, for example, an external devices such as a CPU or the like.

As apparent from the above-mentioned explanation, the determinating function in that when the output signal level output from the mounting or connecting recognition pad 3 is in a grounding level (GND), it is determined that a predetermined electric functional component 4 is mounted on or connected to the printed circuit board 8, is given to the mounting or connecting determining means 9.

In the present invention, the automatic mounting or connecting recognition apparatus 10 is so configured in that the mounting or connecting determining means 9 provided in the mounting or connecting recognition circuit 6, determines whether or not a certain electric functional component 4 is mounted on or connected to the printed circuit board 8 in response to the output signal output from the mounting or connecting recognition pad 3, when at least one of the predetermined connecting terminal 41 of the electric functional component 4, is connected to the mounting or connecting recognition pad 3 provided on one of the electrode 31 provided on the printed circuit board 8 and to which the connecting terminal 41 of the electric functional component 4 is to be connected.

In the present invention, although at least one of the above-mentioned automatic mounting or connecting recognition apparatus 10 is provided on the printed circuit board 8, the number of the mounting or connecting recognition circuit 6 forming the automatic mounting or connecting recognition apparatus 10 may be increased in accordance with the numbers of the electric functional component 4 to be used.

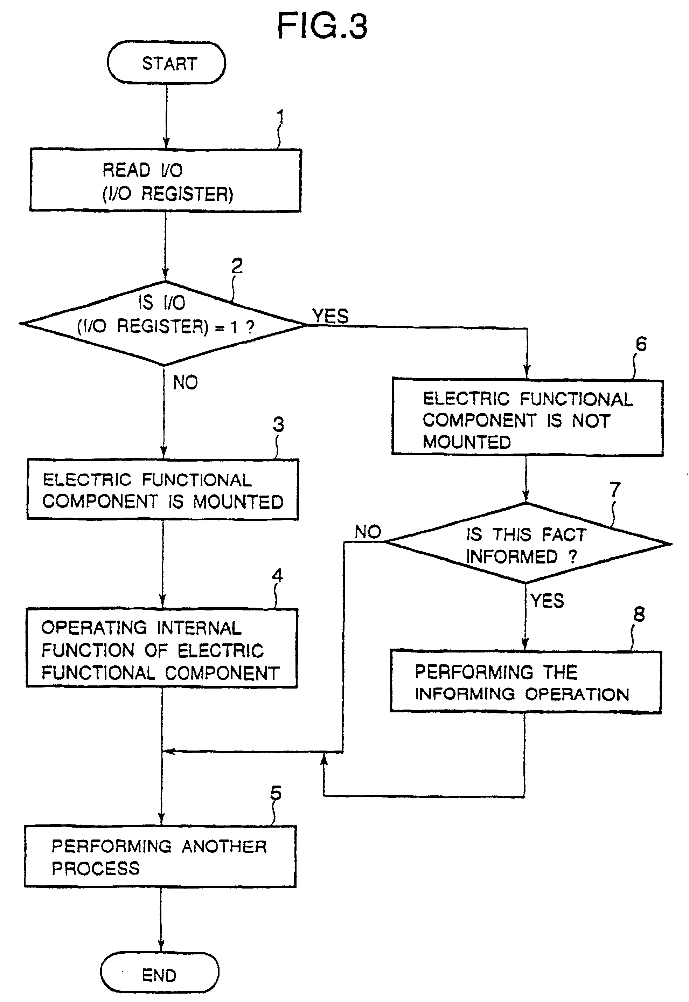

Fig. 3 shows a flow-chart showing one embodiment of a sequential determining process in determining whether or not the electric functional component 4 is mounted on the printed circuit board 8, used in the mounting or connecting determining means 9 of the present invention.

In that, after start, in the step 1, the data in I/O or I/O Register of the mounting or connecting determining means 9 is read and in step 2, the determination in that whether or not the data of the I/O or I/O Register of the mounting or connecting determining means 9 is "1".

In the step 2, the determination is NO, indicating that the electric functional component 4 is correctly mounted on or connected to the printed circuit board 8 (step 3), then go to the step 4 and performing the internal function of the electric functional component 4.

Then go to the step 5 and commanding to perform another processing and go to END.

While, in step 2, the determination is YES meaning that the electric functional component 4 is not correctly mounted on or connected to the printed circuit board 8 (step 6), then go to the step 7 and to determine whether or not this fact should be informed to a pertinent person.

If NO in the step 7, then go to the step 5, while if YES in the step 7, then go to the step 8 and to perform a suitable alarming operation, for example, sound generation or light emission by LED or the like.

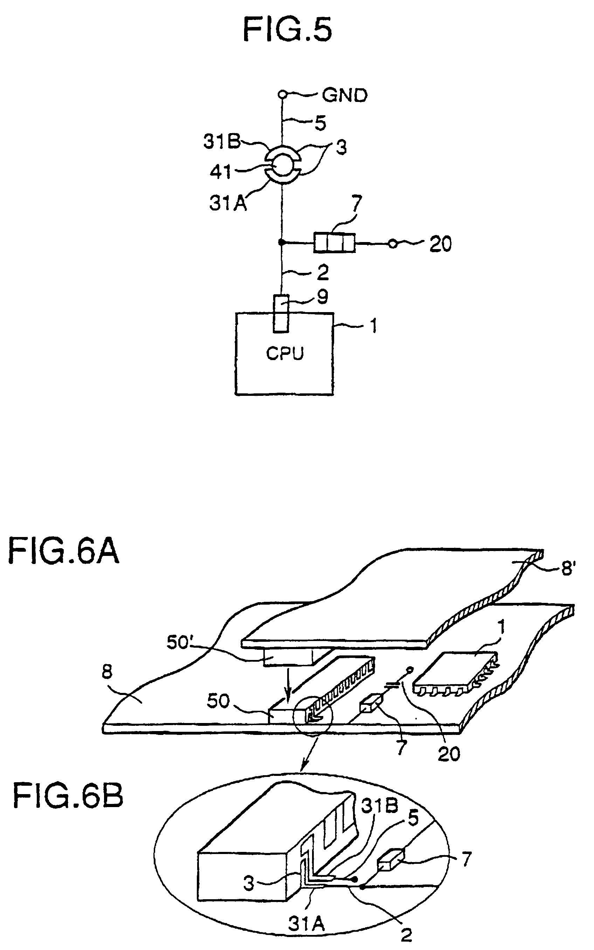

Next, Fig. 4 shows a sectional view of a second embodiment of an automatic mounting or connecting recognition apparatus 10 of the present invention and the basic circuitry construction and the operation thereof are substantially the same as those as disclosed in Figs. 1 and 2, except that the component to the electric functional component 4 is a radial component.

The specific configuration of the mounting or connecting recognition pad 3 of the second embodiment is shown in Fig. 5, in that the sub-electrodes 31A and 31B have curved configurations, respectively.

On the other hand, the present invention can apparently be applied to an embodiment in that a pair of connectors are to be connected to each other.

For example, as shown in Fig. 6, the present invention can be applied to the case in that two printed circuit boards 8 and 8' each having a suitable connectors 50 and 50', respectively are prepared and both of the printed circuit boards 8 and 8' are electrically connected to each other by directly connecting both connectors 50 and 50' to each other, or to the case in that one of the connector is fixedly mounted on a printed circuit board 8 while an opposite connector is connected to a driving device for driving recording mediums or an extended memory device including a hard disk or a SCSI or the like or input interface such as a mouse or the like and these pair of connectors should be connected to each other, or to a case in that an IC card including a memory card is directly connected to a connector provided on the printed circuit board 8.

In these cases, as shown in Fig. 6, for example, an electrode 51 formed in the connector 50 fixedly provided on the printed circuit board 8, has the same configuration as mentioned in Figs. 1, and 2 to form a mounting or connecting recognition pad 3.

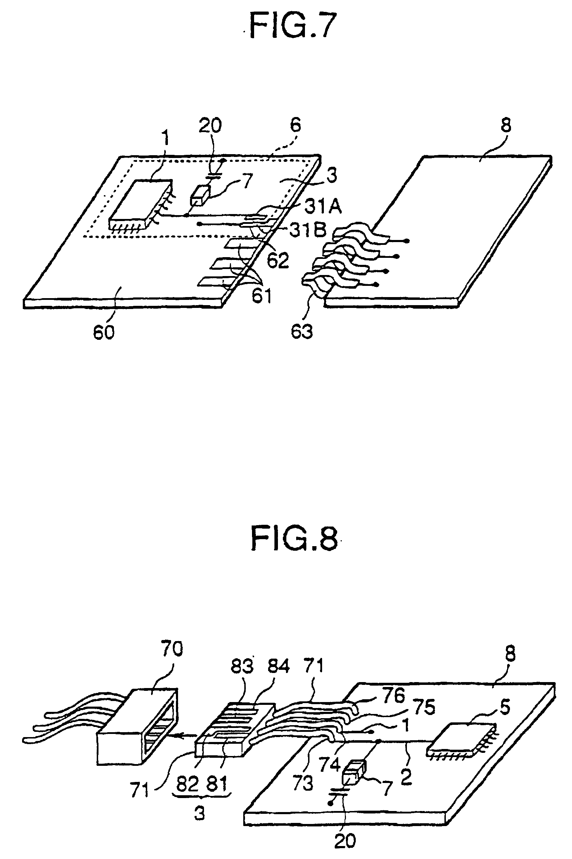

Or, as shown in Fig. 7, in a case in that an IC card 60 is inserted into a suitable connector 63 formed on the printed circuit board 8, one of an electrode 62 of the edge-type connecting electrodes 61 formed on edge portion of the IC card 60 is formed as the mounting or connecting recognition pad 3 as defined by this invention and further the mounting or connecting recognition circuit 6 as defined by the present invention may be arranged inside the IC card 60.

Further, as shown in Fig. 8, in the case in which both connectors 70 and 71 each forming a pair of connectors to each other, are not mounted on the printed circuit board 8, when it is necessary to detect the fact that whether or not the both connectors 70 and 71 are correctly connected to each other, at least one of the connector 71 may be connected to respective electrodes 73 to 76 as provided on the printed circuit board 8, through flexible wirings 72, and then the connecting electrodes 81 and 82 as provided on the connector 71 and being connected to the electrode 73 and 74 of the printed circuit board 8, respectively is formed into the mounting or connecting recognition pad 3 as defined by the present invention as explained above.

The other constructions of the automatic mounting or connecting recognition apparatus 10 of this embodiment is substantially equal to those as shown in Figs. 1 and 2.

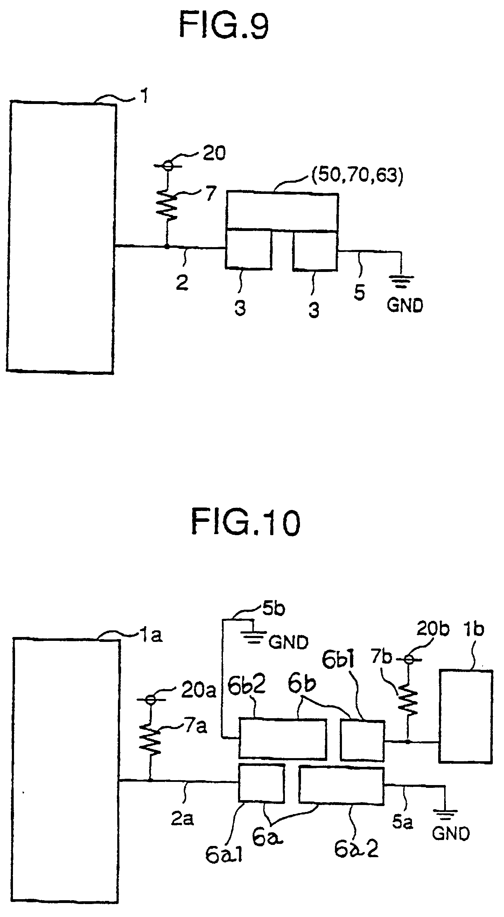

Fig. 9 shows a connecting conditions between the mounting or connecting recognition pad 3 and the connecting connectors 50', 63 and 70 in the above-mentioned embodiments.

Fig. 10 shows another embodiment of the automatic mounting or connecting recognition apparatus 10 of the present invention in that a pair of connectors or a pair of connecting boards are connected to each other.

In this embodiment, each of the connectors or connecting boards 6a and 6b forming a pair thereof is provided with the automatic mounting or connecting recognition apparatus 1a and 1b, respectively, and when both of the connectors or connecting boards 6a and 6b are connected to each other, the determination whether or not the connectors or connected boards are correctly connected to each other can be carried out by both automatic mounting or connecting recognition apparatuses 1a and 1b provided on both connectors or boards.

Note that, in this embodiment the connecting recognition terminal 6a1 and the mounting or connecting recognition pad 6a2 of the connector 6a and the connecting recognition terminal 6b1 and the mounting or connecting recognition pad 6b2 of the connector 6b are the same component, respectively and each component being recognized by the corresponding mating connector.

The fourth embodiment comprises the connectors 6a and 6b to be checked, and each of the connectors 6a and 6b further comprising the connecting recognition terminals 6a1 and 6b1 and grounded connecting recognition terminal 6a2 and 6b2 which recognize whether or not the connectors 6a and 6b to be checked, are connected to each other, utilizing the connection recognizing signal 2a and 2b and the mounting or connecting determining means 9a and 9b each included in the chip 1a and 1b, respectively, which determine whether or not the connectors 6a and 6b are connected to each other in response to signals output from the mounting or connecting recognition pad 6a1 and 6b1 when the connectors 6a and 6b are connected to each other.

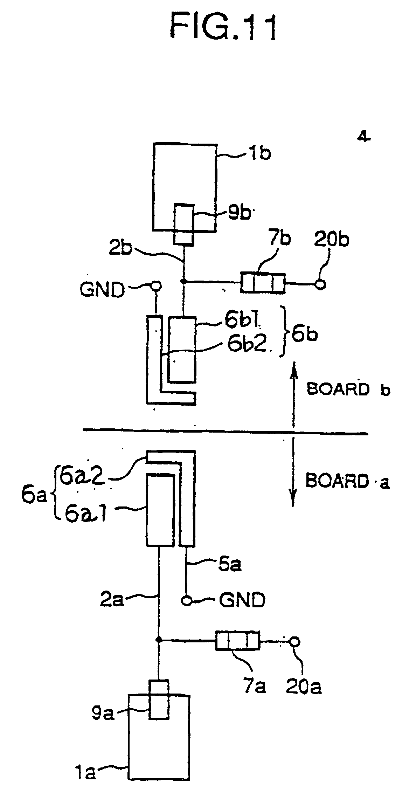

As shown in Fig. 11, the mounting or connecting recognition pad 6a and 6b comprise two separated sub-electrodes 6a1 and 6a2 and 6b1 and 6b2, respectively as the same reason as explained above.

The operation of this embodiment will be explained hereunder with reference to Figs. 10 and 11.

Note that, when the connectors 6a and 6b to be checked, are connected, the sub-electrodes 6a1 and 6b1 are connected to the sub-electrodes 6a2 and 6b2 , respectively, so as to be conducted, the mounting or connecting determining means 9a and 9b included inside the chips 1a and 1b, recognize that the connectors to be checked for 6a and 6b are mounted, by sensing the electric potential of the wirings 2a and 2b transmitted to the mounting or connecting determining means 9a and 9b provided in the chips 1a and 1b, respectively.

Note that in this embodiment wherein a pair of connectors are to be connected to each other, the mounting or connecting determining means 9a and 9b are provided on each of the connectors.

As explained above, as a separate aspect of the present invention which is different from the above-mentioned aspect, the present invention can provide a printed circuit board on which at least one kind of the automatic mounting or connecting recognition apparatus 10 as explained above, is provided.

Further, as a further separate aspect of the present invention, the present invention can provide a connector provided with a mounting or connecting recognition pad 3 thereon which forms a part of the mounting or connecting recognition circuit 6 used for the automatic mounting or connecting recognition apparatus 10 as defined by the present invention as mentioned above.

As apparent from the above-mentioned explanation about the present invention, it is further provided that a method for determining mount or connection of an electric functional component used in an electronic device as explained above, which comprising that when at least one predetermined connecting terminal of the electric functional component 4 is connected to a mounting or connecting recognition pad 3 provided on one of electrodes formed on the printed circuit board 8 and on which or to which the electric functional component 4 is mounted or connected, a mounting or connecting determining means 9 provided in the mounting or connecting recognition circuit 6 determines whether or not the electric functional component 4 is connected to or mounted on the mounting or connecting recognition pad 3, in response to an output signal output from the mounting or connecting recognition pad 3.

In this method, it is preferable that the mounting or connecting determining means 9 determines that the predetermined electric functional component 4 is connected to or mounted on a predetermined portion when a signal level of the output signal output from the mounting or connecting recognition pad 3 shows a ground level(GND).

The first effect of the present invention is a reduction in the cost incurred for component mounting recognition, because the component mounting recognition circuit is mounted to the printed circuit board.

The second effect of the present invention is the ability to use the invention outside the manufacturing process. This is possible because the built-in component mounting recognition circuit can be used to recognize the mode of the apparatus.

## Claims

1. An automatic mounting or connecting recognition apparatus (10) comprising:
a printed circuit board (8); and
at least a mounting or connecting recognition circuit (6) which is provided on said printed circuit board and which recognizes an electric functional component (4) when said electric functional component is mounted on or connected to said printed circuit board.

2. An automatic mounting or connecting recognition apparatus according to claim 1, wherein said electric functional component is a one component selected from electric or electronic components, memory cards, I.C. cards and connecting connectors.

3. An automatic mounting or connecting recognition apparatus according to claim 1, wherein said electric or electronic components include resistors, capacitors, transistors, inductance and various kinds of highly integrated circuit device including micro-computers in chip forms.

4. An automatic mounting or connecting recognition apparatus according to claim 1, wherein said printed circuit board is provided with either one of electrodes on which or in which said electric functional component is mounted or connected and connectors including therein electrodes to which said electric functional component is connected.

5. An automatic mounting or connecting recognition apparatus according to claim 1, wherein said mounting or connecting recognition circuit which is provided on said printed circuit board, comprising a mounting or connecting recognition pad which is provided on one of said electrodes formed on said printed circuit board, and a mounting or connecting determining means which is connected to said mounting or connecting recognition pad and determines whether or not said electric functional component is mounted on said mounting or connecting recognition pad in response to an output signal output from said mounting or connecting recognition pad.

6. An automatic mounting or connecting recognition apparatus according to claim 5, wherein when a pair of connectors are to be connected to each other, at least one of said connectors is fixedly provided on said printed circuit board or is connected to said printed circuit board through pertinent wirings and said mounting or connecting recognition pad being provided on one of electrodes arranged therein being connected to said mounting or connecting determining means.

7. An automatic mounting or connecting recognition apparatus according to claim 6, wherein when a pair of connectors are to be connected to each other, each one of said connectors is provided with said mounting or connecting recognition circuit.

8. An automatic mounting or connecting recognition apparatus according to claim 5, wherein said mounting or connecting determining means has a function in which said means determines that a certain electric functional component is mounted on or connected to a predetermined position when a signal level of said output signal output from said mounting or connecting recognition pad shows a ground level (GND).

9. An automatic mounting or connecting recognition apparatus according to claim 5, wherein said mounting or connecting recognition pad is formed on one of said electrodes provided on said printed circuit board or said connector, and to which opposite electrodes provided on said electric functional component to be connected or mounted thereto, further wherein said mounting or connecting recognition pad being separated into two sub-electrodes each being electrically insulated to each other and said two sub-electrodes being conducted to each other when a predetermined electric terminal provided on said electric functional component is simultaneously connected to both sub-electrodes.

10. An automatic mounting or connecting recognition apparatus according to claim 9, wherein said predetermined electric terminal of said electric functional component to be connected to said mounting or connecting recognition pad is a grounding terminal thereof.

11. An automatic mounting or connecting recognition apparatus according to claim 5, wherein said mounting or connecting determining means is provided in a chip component mounted on said printed circuit board and being different from said electric functional component to be mounted on or connected to said printed circuit board or connector and one terminal of said chip connected to said mounting or connecting determining means, being connected to said one of said electrodes of said mounting or connecting recognition pad.

12. An automatic mounting or connecting recognition apparatus according to claim 11, wherein said chip component is an electronic component selected from micro-computers and highly integrated electric circuit(LSI).

13. A printed circuit board (8) which comprises at least a mounting or connecting recognition circuit (6) provided on it which recognises an electric functional component (4) when said electric functional component is mounted on or connected to said printed circuit board.

14. A connector in combination with a printed circuit board as defined in claim 13, comprising mounting or connecting recognition pad connected to said mounting or connecting recognition circuit.

15. A method for determining mount or connection of an electric functional component (4) used in an electronic device which comprises a printed circuit board (8) and at least a mounting or connecting recognition circuit (6) which is provided on said printed circuit board and which recognizes an electric functional component when said electric functional component is mounted on or connected to said printed circuit board, said method comprising that when at least one predetermined connecting terminal of said electric functional component is connected to a mounting or connecting recognition pad (3) provided on one of electrodes formed on said printed circuit board and on which or to which said electric functional component being mounted or connected , a mounting or connecting determining means (9) provided in said mounting or connecting recognition circuit determines whether or not said electric functional component is connected to or mounted on said mounting or connecting recognition pad, in response to an output signal output from said mounting or connecting recognition pad.

16. A method for determining mount or connection of an electric functional component according to claim 15, wherein said mounting or connecting determining means determines that said predetermined electric functional component is connected to or mounted on a predetermined portion when a signal level of said output signal output from said mounting or connecting recognition pad shows a ground level(GND).

## Patentansprüche

1. Eine Vorrichtung (10) zum automatischen Erkennen einer Anordnung/Lagerung oder Verbindung, umfassend
eine gedruckte Leiterplatte (8); und
wenigstens eine Schaltung (6) zum Erkennen einer Anordnung oder Verbindung, die auf der gedruckten Leiterplatte vorgesehen ist und eine elektrische Funktionskomponente (4) erkennt, wenn diese elektrische Funktionskomponente auf der gedruckten Leiterplatte angeordnet oder mit dieser verbunden ist.

2. Eine Vorrichtung zum automatischen Erkennen einer Anordnung oder Verbindung nach Anspruch 1, wobei die elektrische Funktionskomponente eine Komponente, ausgewählt aus elektrischen oder elektronischen Komponenten, Speicherkarten, I.C.-Karten und Verbindungsteilen ist.

3. Eine Vorrichtung zum automatischen Erkennen einer Anordnung oder Verbindung nach Anspruch 1, wobei die elektrischen oder elektronischen Komponenten Widerstände, Kondensatoren, Transistoren, Induktivitäten und verschiedene Arten hochintegrierter Schaltungseinrichtungen einschließlich Mikrocomputern in Chipform umfassen.

4. Eine Vorrichtung zum automatischen Erkennen einer Anordnung oder Verbindung nach Anspruch 1, wobei die gedruckte Leiterplatte mit einer der Elektroden versehen ist, auf der die elektrische Funktionskomponente angeordnet oder mit der diese verbunden ist, und mit Verbindern einschließlich Elektroden, mit denen die elektrische Funktionskomponente verbunden ist.

5. Eine Vorrichtung zum automatischen Erkennen einer Anordnung oder Verbindung nach Anspruch 1, wobei die Schaltung zum Erkennen einer Anordnung oder Verbindung, die auf der gedrückten Leiterplatte vorgesehen ist, eine Anschlußfläche zum Erkennen einer Anordnung oder Verbindung umfaßt, die auf einer der auf der gedruckten Leiterplatte gebildeten Elektroden vorgesehen ist, und ein Mittel zum Bestimmen einer Anordnung oder Verbindung, das mit der Anschlußfläche zum Erkennen einer Anordnung oder Verbindung verbunden ist und in Reaktion auf ein Ausgangssignal, das von der Anschlußfläche zum Erkennen einer Anordnung oder Verbindung ausgegeben wird, bestimmt, ob die elektrische Funktionskomponente auf der Anschlußfläche zum Erkennen einer Anordnung oder Verbindung angebracht ist.

6. Eine Vorrichtung zum automatischen Erkennen einer Anordnung oder Verbindung nach Anspruch 5, wobei dann, wenn ein Paar Verbinder miteinander zu verbinden ist, wenigstens einer der Verbinder fest auf der gedruckten Leiterplatte vorgesehen oder mit der gedruckten Leiterplatte durch geeignete Drähte verbunden ist und die Anschlußfläche zum Erkennen einer Anordnung oder Verbindung auf einer von Elektroden vorgesehen ist, die daran angeordnet und mit dem Mittel zum Bestimmen einer Anordnung oder Verbindung verbunden sind.

7. Eine Vorrichtung zum automatischen Erkennen einer Anordnung oder Verbindung nach Anspruch 6, wobei dann, wenn ein Paar Verbinder miteinander zu verbinden ist, jeder der Verbinder mit der Schaltung zum Erkennen einer Anordnung oder Verbindung versehen ist.

8. Eine Vorrichtung zum automatischen Erkennen einer Anordnung oder Verbindung nach Anspruch 5, wobei das Mittel zum Bestimmen einer Anordnung oder Verbindung eine Funktion aufweist, bei der das Mittel bestimmt, daß eine bestimmte elektrische Funktionskomponente auf einer vorbestimmten Position angebracht oder damit verbunden ist, wenn das Signalniveau des von der Anschlußfläche zum Erkennen einer Anordnung oder Verbindung ausgegebenen Ausgangssignals ein Grundniveau (GND) zeigt.

9. Eine Vorrichtung zum automatischen Erkennen einer Anordnung oder Verbindung nach Anspruch 5, wobei die Anschlußfläche zum Erkennen einer Anordnung oder Verbindung auf einer der Elektroden ausgebildet ist, die auf der gedruckten Leiterplatte oder dem Verbinder vorgesehen sind, und mit der entgegengesetzte, auf der elektrischen Funktionskomponente vorgesehene Elektroden zu verbinden oder darauf anzuordnen sind, wobei weiter die Anschlußfläche zum Erkennen einer Anordnung oder Verbindung in zwei Teilelektroden aufgeteilt ist, von denen jede elektrisch gegenüber der anderen isoliert ist und wobei die zwei Teilelektroden miteinander leitend sind, wenn ein auf der elektrischen Funktionskomponente vorgesehener vorbestimmter elektrischer Anschluß gleichzeitig mit beiden Teilelektroden verbunden wird.

10. Eine Vorrichtung zum automatischen Erkennen einer Anordnung oder Verbindung nach Anspruch 9, wobei der vorbestimmte elektrische Anschluß der elektrischen Funktionskomponente, die mit der Anschlußfläche zum Erkennen einer Anordnung oder Verbindung zu verbinden ist, ein Masseanschluß davon ist.

11. Eine Vorrichtung zum automatischen Erkennen einer Anordnung oder Verbindung nach Anspruch 5, wobei das Mittel zum Bestimmen einer Anordnung oder Verbindung in einer auf der gedruckten Leitertafel angeordneten Chipkomponente vorgesehen und von der elektrischen Funktionskomponente, die an der gedruckten Leiterplatte oder dem Verbinder anzuordnen oder damit zu verbinden ist, verschieden ist, und wobei ein Anschluß des mit den Mitteln zum Bestimmen einer Anordnung oder Verbindung verbundenen Chips mit einer der Elektroden der Anschlußfläche zum Erkennen einer Anordnung oder Verbindung verbunden ist.

12. Eine Vorrichtung zum automatischen Erkennen einer Anordnung oder Verbindung nach Anspruch 11, wobei die Chipkomponente eine elektronische Komponente ist, die aus Mikrocomputern und hoch integrierten elektrischen Schaltungen (LSI) ausgewählt ist.

13. Eine gedruckte Leiterplatte (8), die wenigstens eine darauf vorgesehene Schaltung (6) zum Erkennen einer Anordnung oder Verbindung umfaßt, die eine elektrische Funktionskomponente (4) erkennt, wenn die elektrische Funktionskomponente an der gedruckten Leiterplatte angeordnet oder damit verbunden wird.

14. Ein Verbinder in Kombination mit einer gedruckten Leiterplatte nach Anspruch 13, umfassend eine Anschlußfläche zum Erkennen einer Anordnung oder Verbindung, die mit der Schaltung zum Erkennen einer Anordnung oder Verbindung verbunden ist.

15. Ein Verfahren zum Bestimmen der Anordnung oder Verbindung einer elektrischen Funktionskomponente (4), verwendet in einer elektronischen Einrichtung, die eine elektrische Leiterplatte (8) und mindestens eine Schaltung (6) zum Erkennen einer Anordnung oder Verbindung umfaßt, die auf der gedruckten Leiterplatte vorgesehen ist und eine elektrische Funktionskomponente erkennt, wenn die elektrische Funktionskomponente an der gedruckten Leiterplatte angeordnet oder damit verbunden ist, wobei das Verfahren den Schritt umfaßt, daß, wenn wenigstens ein vorbestimmter Verbindungsanschluß der elektrischen Funktionskomponente mit einer Anschlußfläche (3) zum Erkennen einer Anordnung oder Verbindung verbunden ist, die an einer der an der gedruckten Leiterplatte ausgebildeten Elektroden vorgesehen ist und auf der die elektrische Funktionskomponente angeordnet oder mit der diese verbunden ist, wobei ein Mittel (9) zum Bestimmen einer Anordnung oder Verbindung, das an der Schaltung zum Erkennen einer Anordnung oder Verbindung vorgesehen ist, in Reaktion auf ein Ausgangssignal, das von der Anschlußfläche zum Erkennen einer Anordnung oder Verbindung ausgegeben wird, bestimmt, ob die elektrische Funktionskomponente mit der Anschlußfläche zum Erkennen einer Anordnung oder Verbindung verbunden oder daran angeordnet ist.

16. Ein Verfahren zum Bestimmen der Anordnung oder Verbindung einer elektrischen Funktionskomponente nach Anspruch 15, wobei das Mittel zum Erkennen einer Anordnung oder Verbindung bestimmt, daß die vorbestimmte elektrische Funktionskomponente mit einem vorbestimmten Abschnitt verbunden oder daran angeordnet ist, wenn das Signalniveau des von der Anschlußfläche zum Erkennen einer Anordnung oder Verbindung ausgegebenen Ausgangssignals Masseniveau (GND) zeigt.

## Revendications

1. Appareil de détection automatique de montage ou de connexion (10), comprenant :
une carte de circuit imprimé (8) ; et
au moins un circuit de détection de montage et de connexion (6) qui est prévu sur ladite carte de circuit imprimé et qui détecte un composant électrique fonctionnel (4) lorsque ledit composant électrique fonctionnel est monté sur, ou est connecté à ladite carte de circuit imprimé.

2. Appareil de reconnaissance automatique de montage ou de connexion selon la revendication 1, dans lequel ledit composant électrique fonctionnel est un composant sélectionné parmi des composants électriques ou électroniques, des cartes de mémoire, des cartes de circuit intégré et des connecteurs de connexion.

3. Appareil de reconnaissance automatique de montage ou de connexion selon la revendication 1, dans lequel lesdits composants électriques ou électroniques comprennent des résistances, des condensateurs, des transistors, des inductances et divers types de dispositifs à circuits à haut degré d'intégration, incluant des micro-calculateurs sous forme de puces.

4. Appareil de détection automatique de montage ou de connexion selon la revendication 1, dans lequel ladite carte de circuit imprimé est munie soit d'une de plusieurs électrodes sur lesquelles ou auxquelles ledit composant électrique fonctionnel est monté ou est connecté, et de connecteurs qui comportent des électrodes auxquelles est connecté ledit composant électrique fonctionnel.

5. Appareil de détection automatique de montage ou de connexion selon la revendication 1, dans lequel ledit circuit de détection de montage ou de connexion qui est prévu sur ladite carte de circuit imprimé, comprend une plage de détection de montage ou de connexion qui est prévue sur l'une desdites électrodes formées sur ladite carte de circuit imprimé, et un moyen de détermination de montage ou de connexion qui est connecté à ladite plage de détection de montage ou de connexion et qui détermine si oui ou non ledit composant électrique fonctionnel est monté sur ladite plage de détection de montage ou de connexion en réponse à un signal de sortie provenant de ladite plage de détection de montage ou de connexion.

6. Appareil de détection automatique de montage ou de connexion selon la revendication 5, dans lequel, lorsqu'une paire de connecteurs doivent être connectés l'un à l'autre, au moins l'un desdits connecteurs est prévu de façon fixe sur ladite carte de circuit imprimé ou est connecté à ladite carte de circuit imprimé. par des câblages pertinents et ladite plage de détection de montage ou de connexion est prévue sur l'une des électrodes disposées dans celui-ci en-.-étant connectée audit moyen de détermination de montage ou de connexion.

7. Appareil de détection automatique de montage ou de connexion selon la revendication 6, dans lequel, lorsqu'une paire de connecteurs doivent être connectés l'un à l'autre, chacun desdits connecteurs est muni dudit circuit de détection de montage ou de connexion.

8. Appareil de détection automatique de montage ou de connexion selon la revendication 5, dans lequel ledit moyen de détermination de montage ou de connexion remplit une fonction selon laquelle ledit moyen détermine qu'un certain composant électrique fonctionnel est monté ou est connecté à une position prédéterminée lorsqu'un niveau de signal dudit signal de sortie provenant de ladite plage de détection de montage ou de connexion présente un niveau de masse (GND).

9. Appareil de détection automatique de montage ou de connexion selon la revendication 5, dans lequel ladite plage de détection de montage ou de connexion est formée sur l'une desdites électrodes prévues sur ladite carte de circuit imprimé ou ledit connecteur, et pour lesquelles des électrodes opposées sont prévues sur ledit composant électrique fonctionnel pour être connecté à celles-ci ou être monté sur celles-ci, dans lequel, en outre, ladite plage de détection de montage ou de connexion est séparée en deux sous-électrodes qui sont chacune électriquement isolées l'une de l'autre, lesdites deux sous-électrodes étant en contact l'une avec l'autre lorsqu'une borne électrique prédéterminée prévue sur ledit composant électrique fonctionnel est simultanément connecté aux deux sous-électrodes.

10. Appareil de détection automatique de montage ou de connexion selon la revendication 9, dans lequel ladite borne électrique prédéterminée dudit composant électrique fonctionnel devant être connecté à ladite plage de détection de montage ou de connexion est une borne de mise à la masse de celui-ci.

11. Appareil de détection automatique de montage ou de connexion selon la revendication 5, dans lequel ledit moyen de détermination de montage ou de connexion est prévu dans un composant de puce monté sur ladite carte de circuit imprimé et est différent dudit composant électrique fonctionnel devant être monté sur, ou connecté à ladite carte de circuit imprimé ou audit connecteur, et une borne de ladite puce connectée audit moyen de détermination de montage ou de connexion étant connectée à ladite une desdites électrodes de ladite plage de détection de montage ou de connexion.

12. Appareil de détection automatique de montage ou de connexion selon la revendication 11, dans lequel ledit composant de puce est un composant électronique sélectionné parmi des micro-calculateurs et des circuits électriques à haut degré d'intégration (LSI).

13. Carte de circuit imprimé (8) qui comprend au moins un circuit de détection de montage ou de connexion (6) prévu sur celle-ci, qui détecte un composant électrique fonctionnel (4) lorsque ledit composant électrique fonctionnel est monté sur, ou est connecté à ladite carte de circuit imprimé.

14. Connecteur combiné à une carte de circuit imprimé selon la revendication 13, comprenant une plage de détection de montage ou de connexion connectée audit circuit de détection de montage ou de connexion.

15. Procédé de détermination du montage ou de la connexion d'un composant électrique fonctionnel (4) utilisé dans un dispositif électronique qui comprend une carte de circuit imprimé (8) et au moins un circuit de détection de montage et de connexion (6) qui est prévu sur ladite carte de circuit imprimé et qui détecte un composant électrique fonctionnel lorsque ledit composant électrique fonctionnel est monté sur ou est connecté à ladite carte de circuit imprimé, ledit procédé consistant en ce que, lorsqu'au moins une borne de connexion prédéterminée dudit composant électrique fonctionnel est connectée à une plage de détection de montage ou de connexion (3) prévue sur l'une des électrodes formées sur ladite carte de circuit imprimé et sur laquelle, ou à laquelle ledit composant électrique fonctionnel est monté ou est connecté, un moyen de détermination de montage ou de connexion (9) prévu dans ledit circuit de détection de montage ou de connexion détermine si oui ou non ledit composant électrique fonctionnel est connecté à, ou est monté sur ladite plage de détection de montage ou de connexion, en réponse à un signal de sortie provenant de ladite plage de détection de montage ou de connexion.

16. Procédé de détermination du montage ou de la connexion d'un composant électrique fonctionnel selon la revendication 15, dans lequel ledit moyen de détermination de montage ou de connexion détermine qu'un composant électrique fonctionnel prédéterminé est connecté à, ou est monté sur une partie prédéterminée lorsqu'un niveau de signal dudit signal de sortie provenant de ladite plage de détection de montage ou de connexion présente un niveau de masse (GND).
